# EUROPEAN PATENT APPLICATION

(11) **EP 4 693 750 A1**
(43) Date of publication of application: **11.02.2026**
(21) Application number: 24797304.3
(22) Date of filing: 05.04.2024
(51) Int. Cl.: H01R 4/48, H01R 4/58, H01R 12/63, H01R 12/75, H01R 12/53, H01B 7/10, G06N 3/08

(54) **ELECTRONIC DEVICE INCLUDING CABLE CONNECTION STRUCTURE**

(30) Priority: 24.04.2023 KR 20230053417; 31.05.2023 KR 20230069847
(71) Applicant: Samsung Electronics Co., Ltd., Suwon-si, Gyeonggi-do 16677 (KR)
(72) Inventor: LIM, Hyosang, Suwon-si Gyeonggi-do 16677 (KR); JEON, Jonghyeok, Suwon-si Gyeonggi-do 16677 (KR); PAENG, Jiman, Suwon-si Gyeonggi-do 16677 (KR); KIM, Donghak, Suwon-si Gyeonggi-do 16677 (KR); LEE, Kihee, Suwon-si Gyeonggi-do 16677 (KR)
(74) Representative: Nederlandsch Octrooibureau
(86) International application number: PCT/KR2024/004457
(87) International publication number: WO 2024/225647

(57) **Abstract**

According to an embodiment, provided is an electronic device. The electronic device may comprise: a printed circuit board; a cable including a signal wire, a ground wire, and an insulating cover that surrounds the signal wire and the ground wire; a cable tube surrounding the end of the cable; and a cable connection member arranged on the printed circuit board. The cable tube may include: a first conductive tube electrically connected to the signal wire; and a second conductive tube spaced apart from the first conductive tube and electrically connected to the ground wire. The cable connection member may include: a first connection member electrically connected to the first conductive tube; and a second connection member electrically connected to the second conductive tube.

## Description

### Technical Field

Embodiments of the disclosure relate to a cable connection structure and an electronic device including the same.

### Background Art

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As the demand for mobile communication increases, and the degree of integration of electronic devices increases, various technologies have been developed to enhance the portability of the electronic device and user convenience in use of multimedia functions.

The above-described information may be provided as related art for the purpose of helping understanding of the disclosure. No claim or determination is made as to whether any of the foregoing is applicable as background art in relation to the disclosure.

### Detailed Description of the Invention

### Technical Solution

According to an embodiment of the disclosure, an electronic device may be provided. The electronic device may comprise a printed circuit board, a cable including a signal wire, a ground wire, and an insulating sheath surrounding the signal wire and the ground wire, a cable tube disposed to surround an end portion of the cable, and a cable connection member disposed on the printed circuit board. The cable tube may include a first conductive tube to be electrically connected to the signal wire and a second conductive tube spaced apart from the first conductive tube and to be electrically connected to the ground wire. The cable connection member may include a first connection member to be electrically connected to the first conductive tube and a second connection member to be electrically connected to the second conductive tube.

According to an embodiment of the disclosure, there may be provided a method for manufacturing a cable tube. The method for manufacturing the cable tube may comprise a process of processing an end portion of the cable, a process of mounting an insulating tube on the end portion of the cable, a process of mounting a ground tube on the insulating tube, and a process of mounting a signal tube on an end portion of the signal wire and the insulating tube.

### Brief Description of Drawings

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to an embodiment of the disclosure;
FIG. 2 is a front perspective view illustrating an electronic device according to an embodiment of the disclosure;
FIG. 3 is a rear perspective view illustrating an electronic device according to an embodiment of the disclosure;
FIG. 4 is a front exploded perspective view illustrating an electronic device according to an embodiment of the disclosure;
FIG. 5 is a rear exploded perspective view illustrating an electronic device according to an embodiment of the disclosure;
FIG. 6A is an enlarged view of area D of FIG. 5;
FIG. 6B is an enlarged view of area E of FIG. 5;
FIG. 7 is a perspective view illustrating a cable connection structure according to an embodiment of the disclosure;
FIG. 8 is an exploded perspective view illustrating a cable assembly according to an embodiment of the disclosure;
FIG. 9 is a cross-sectional view illustrating a cable assembly according to an embodiment of the disclosure;
FIG. 10 is a side view illustrating a cable connection structure before assembly according to an embodiment of the disclosure;
FIG. 11a is a cross-sectional view taken along line F-F' of FIG. 10;
FIG. 11B is a cross-sectional view illustrating the cable connection structure of FIG. 11A in an assembled state;
FIG. 12 is a perspective view illustrating a cable connection member according to an embodiment of the disclosure;
FIG. 13 is a plan view illustrating a cable connection member according to an embodiment of the disclosure;
FIG. 14A is a side view illustrating a cable connection structure according to an embodiment of the disclosure;
FIG. 14B is a side view illustrating a cable connection structure according to an embodiment of the disclosure;
FIG. 15A is a side view illustrating a cable according to an embodiment of the disclosure;
FIG. 15B is a side view illustrating a cable and an insulating tube according to an embodiment of the disclosure;
FIG. 15C is a side view illustrating a cable, a second conductive tube, and an insulating tube according to an embodiment of the disclosure;
FIG. 15D is a side view illustrating a state in which a signal line of a cable is processed in FIG. 15C;
FIG. 15E is a side view illustrating a cable, a first conductive tube, a second conductive tube, and an insulating tube according to an embodiment of the disclosure; and
FIG. 16 is a flowchart illustrating a method for manufacturing a cable tube according to an embodiment of the disclosure.

Throughout the drawings, like reference numerals may be assigned to like parts, components, and/or structures.

### Mode for Carrying out the Invention

The following description taken in conjunction with the accompanying drawings is provided to aid a comprehensive understanding of various embodiments of the disclosure as defined by the claims and equivalents thereto. The following description may include various specific details to aid understanding, but these may be considered exemplary only. Hence, it should be appreciated by one of ordinary skill in the art that various changes or modifications may be made to the embodiments without departing from the spirit or scope of the present invention. Descriptions of well-known functions and configurations may be omitted for clarity and conciseness.

The terms and words used in the following description and claims are not limited to the dictionary meaning, but are used only by the inventors to enable a clear and consistent understanding of the disclosure. Accordingly, it will be apparent to one of ordinary skill in the art that the following description of various embodiments of the present invention is provided by way of example only and not to limit the disclosure as defined by the appended claims and equivalents thereof.

As used herein, the singular forms "a," "an," and "the" are intended to include the plural forms as well, unless the context clearly indicates otherwise. For example, the phrase "surface of a component" may refer to one or more of surfaces of the component.

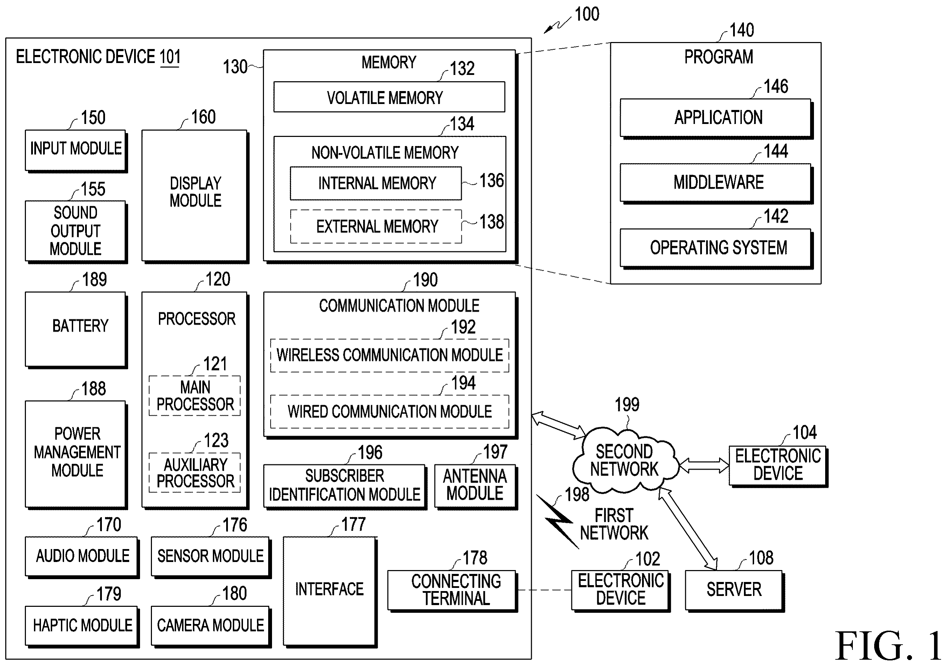

FIG. 1 is a block diagram illustrating an electronic device in a network environment according to an embodiment of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of processes to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

In the following detailed description, a length direction, a width direction, and/or a thickness direction of the electronic device may be mentioned and may be defined as a 'Y-axis direction,' 'X-axis direction', and/or 'Z-axis direction,' respectively. In an embodiment, 'negative/positive (-/+)' may be mentioned together with the Cartesian coordinate system exemplified in the drawings with respect to the direction in which the component is oriented. For example, the front surface of the electronic device or housing may be defined as a 'surface facing in the +Z direction,' and the rear surface may be defined as a 'surface facing in the -Z direction'. In an embodiment, the side surface of the electronic device or housing may include an area facing in the +X direction, an area facing in the +Y direction, an area facing in the -X direction, and/or an area facing in the -Y direction. In another embodiment, the 'X-axis direction' may mean including both the '-X direction' and the '+X direction'. It should be noted that the directions are so defined with respect to the Cartesian coordinate system shown in the drawings for the sake of brevity of description, and the description of these directions or components do not limit an embodiment of the disclosure. For example, the direction in which the front surface or rear surface faces may be varied depending on the unfolded state or folded state of the electronic device, and the above-mentioned directions may be interpreted as different ones depending on the user's way to grip.

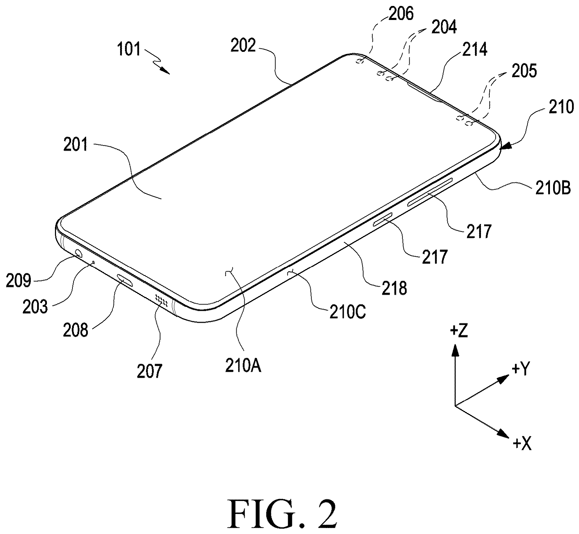

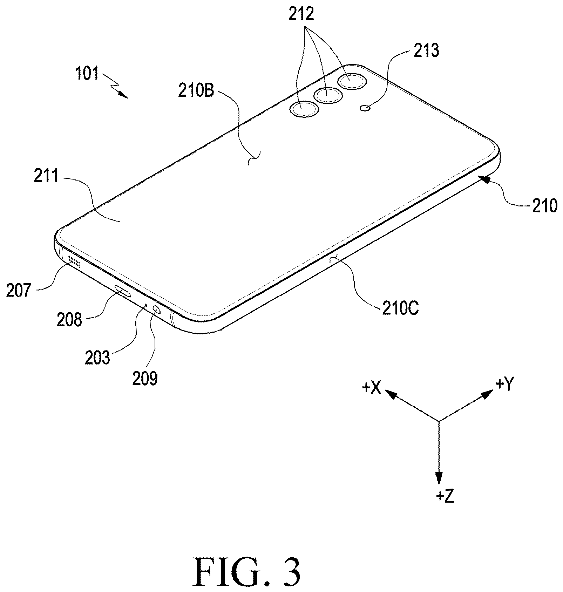

FIG. 2 is a front perspective view illustrating an electronic device according to an embodiment of the disclosure. FIG. 3 is a perspective view illustrating a rear surface of the electronic device of FIG. 2 according to an embodiment of the disclosure. The configuration of the electronic device 101 of FIGS. 2 and 3 may be identical in whole or part to the configuration of the electronic device 101 of FIG. 1.

Referring to FIGS. 2 and 3, according to an embodiment, an electronic device 101 may include a housing 210 including a first side (or front surface) 210A, a second side (or rear surface) 210B, and a side surface 210C surrounding the space between the first surface 210A and the second surfaces 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or rear plate 211 may be substantially flat and, for example, may not include an area bending and extending. When an area bending and extending is included, the thickness of the electronic device 101 at the portion including the area bending and extending may be smaller than the thickness of the rest.

According to an embodiment, the electronic device 101 may include at least one of a display 201, an audio module (not illustrated) (e.g., the audio module 170 of FIG. 1) including at least one sound hole 203, 207, and 214, a sensor module 204 (e.g., the sensor module 176 of FIG. 1), camera modules 205, 212, and 213 (e.g., the camera module 180 of FIG. 1), a key input device 217 (e.g., the input module 150 of FIG. 1), a light emitting element 206, and connector holes 208 and 209 (e.g., the connecting terminal 178 of FIG. 1), and a cable 250. In an embodiment, the electronic device 101 may exclude at least one (e.g., the key input device 217 or the light emitting device 206) of the components or may add other components.

According to an embodiment, the display 201 may be visually revealed through, e.g., a majority portion of the front plate 202. In an embodiment, at least a portion of the display 201 may be visually exposed through the front plate 202 forming the first surface 210A, or through a portion of the side surface 210C. In an embodiment, the edge of the display 201 may be formed to be substantially the same in shape as an adjacent outer edge of the front plate 202. In an embodiment (not illustrated), the interval between the outer edge of the display 201 and the outer edge of the front plate 202 may remain substantially even to give a larger area of visual exposure of the display 201.

In an embodiment (not illustrated), the screen display region of the display 201 may have a recess or opening in a portion thereof, and at least one or more of the sound hole 214, sensor module 204, camera module 205, and light emitting device 206 may be aligned with the recess or opening. In an embodiment (not illustrated), at least one or more of the sound module 214, sensor module 204, camera module 205, fingerprint sensor (not illustrated), and light emitting device 206 may be included on the rear surface of the screen display area of the display 201. In an embodiment (not illustrated), the display 201 may be disposed to be coupled with, or adjacent, a touch detecting circuit, a pressure sensor capable of measuring the strength (pressure) of touches, and/or a digitizer for detecting a magnetic field-type stylus pen. In an embodiment, at least a portion of the sensor module 204 and/or at least a portion of the key input device 217 may be disposed on the side surface 210C.

According to an embodiment, the audio module (not illustrated) may include a microphone hole 203 and sound holes 207 and 214. A microphone for acquiring external sounds may be disposed in the microphone hole 203. In an embodiment, a plurality of microphones may be disposed to detect the direction of the sound. According to an embodiment, the sound holes 207 and 214 may include an external sound hole 207 and a phone receiver hole 214. In an embodiment, the sound holes 207 and 214 and the microphone hole 203 may be implemented as a single hole, or speakers may be included in the audio module without the sound holes 207 and 214 (e.g., piezo speakers).

According to an embodiment, the sensor module 204 may generate an electrical signal or a data value corresponding to an internal operating state of the electronic device 101 or an external environmental state. The sensor module 204 may include, e.g., a first sensor module 204 (e.g., a proximity sensor) and/or a second sensor module (not illustrated) (e.g., a fingerprint sensor) disposed on the front surface 210A of the housing 210. According to an embodiment, an additional sensor module may be disposed on the second surface 210B of the housing 210. The fingerprint sensor (not illustrated) may be disposed on the second surface 210B or side surface 210C as well as the first surface 210A (e.g., the display 201) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 204.

According to an embodiment, the camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, one or more lenses (an infrared (IR) camera, a wide-angle lens, and a telephoto lens) and image sensors may be disposed on one surface of the electronic device 101. In an embodiment, the flash 213 may radiate infrared light. For example, the infrared light radiated from the flash 213 and reflected by the object may be received through the sensor module (not illustrated) disposed on the second surface 210B of the housing 210. The electronic device 101 or the processor of the electronic device 101 may detect depth information about the subject based on the time point when the infrared light is received from the sensor module.

According to an embodiment, the key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 201. In an embodiment, the key input device may include the sensor module disposed on the second surface 210B of the housing 210.

According to an embodiment, the light emitting device 206 may be disposed on the first surface 210A of the housing 210, for example. The light emitting device 206 may provide, e.g., information about the state of the electronic device 101 in the form of light. In an embodiment, the light emitting device 206 may provide a light source that interacts with, e.g., the process of the camera module 205. The light emitting device 206 may include, e.g., an light emitting diode (LED), an infrared (IR) LED, or a xenon lamp.

According to an embodiment, the connector holes 208 and 209 may include, e.g., a first connector hole 208 for receiving a connector (e.g., a universal serial bus (USB) connector) for transmitting or receiving power and/or data to/from an external electronic device and/or a second connector hole (e.g., an earphone jack) 209 for receiving a connector for transmitting or receiving audio signals to/from the external electronic device.

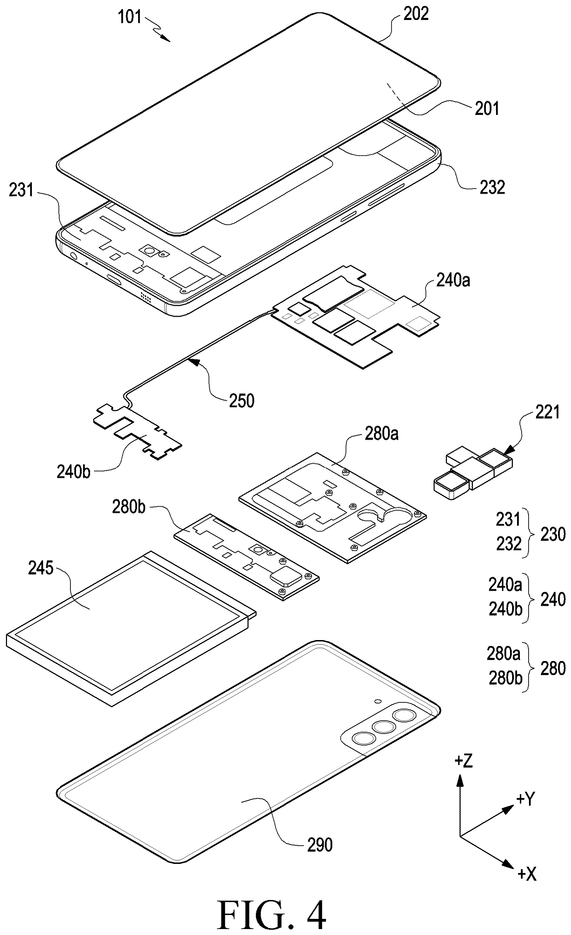

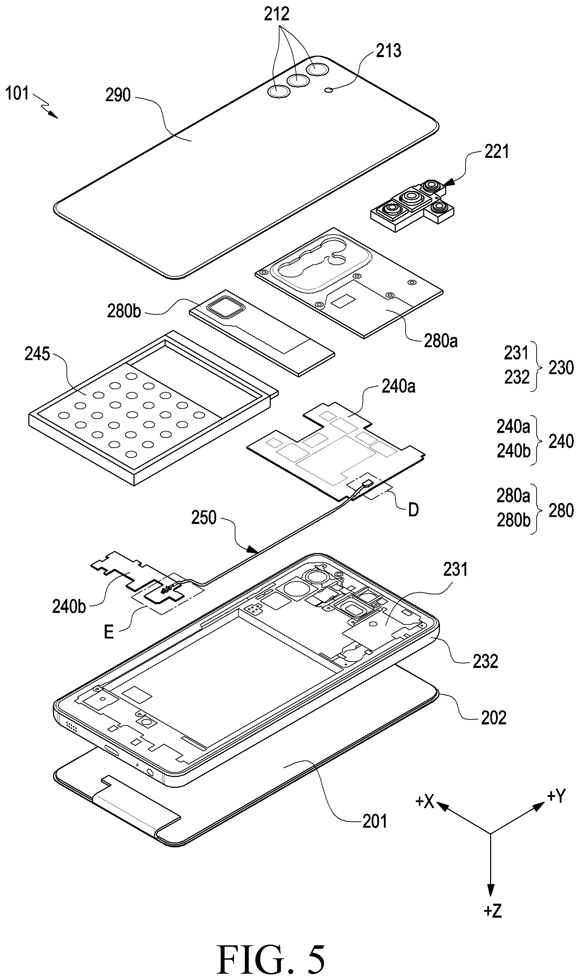

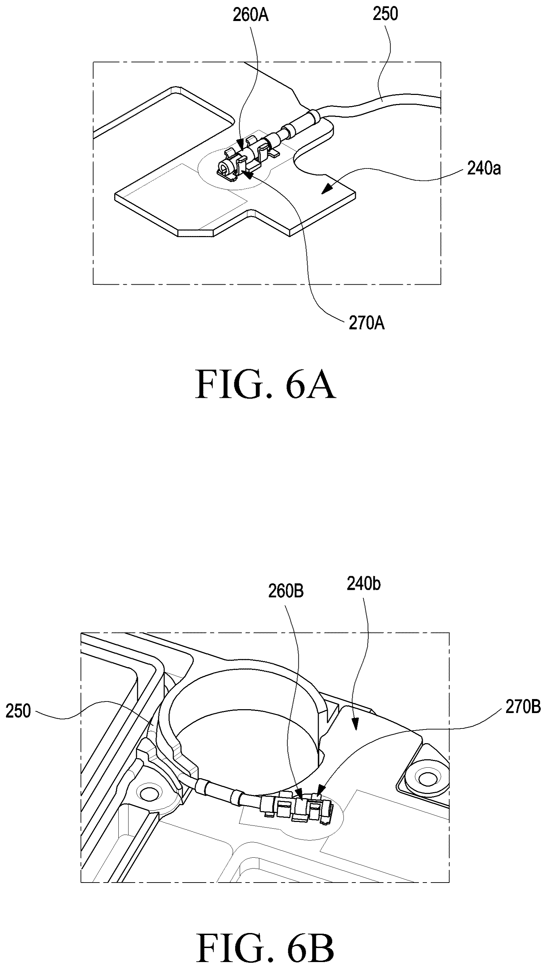

FIG. 4 is an exploded front perspective view illustrating the electronic device 101 of FIG. 2, according to an embodiment of the disclosure. FIG. 5 is a rear exploded perspective view illustrating the electronic device 101 of FIG. 2 according to an embodiment of the disclosure. FIG. 6A is an enlarged view of area D of FIG. 5. FIG. 6B is an enlarged view of area E of FIG. 5.

Referring to FIGS. 4 and 5, the electronic device 101 (e.g., the electronic device 101 of FIG. 1 and/or the electronic device 101 of FIG. 2 or 3) may include a support structure 231 (e.g., a bracket), a side bezel structure (or side bezel structure) 232, a front plate 202 (e.g., the front plate 202 of FIG. 2), a display 201 (e.g., the display 201 of FIG. 2), at least one printed circuit board (or substrate assembly) 240a, 240b, a rear case 280, a battery 245 (e.g., the battery 189 of FIG. 1), an antenna (not illustrated) (e.g., the antenna module 197 of FIG. 1), a camera module 221 (e.g., the camera module 180 of FIG. 1), a cable 250, and/or a rear plate 290 (e.g., the rear plate 211 of FIG. 3). According to an embodiment, the electronic device 101 may omit at least one (e.g., the support structure 231 or the rear case 280) of the components or may add other components. At least one of the components of the electronic device 101 may be the same or similar to at least one of the components of the electronic device 101 of FIG. 2 or 3 and no duplicate description is made below.

According to an embodiment, the printed circuit board 240a and 240b may include a first circuit board 240a disposed in a first area (e.g., an upper space of the battery 245 inside the electronic device 101) of the electronic device 101 and/or a second circuit board 240b disposed in a second area (e.g., a lower space of the battery 245 inside the electronic device 101).

Referring to FIGS. 6A and 6B, the electronic device 101 includes a cable 250, and the cable 250 may electrically connect the first circuit board 240a to the second circuit board 240b. For example, the cable 250 may be a coaxial cable. For example, the cable 250 may be disposed on the inner surface of the side structure 232 or adjacent to the side structure 232.

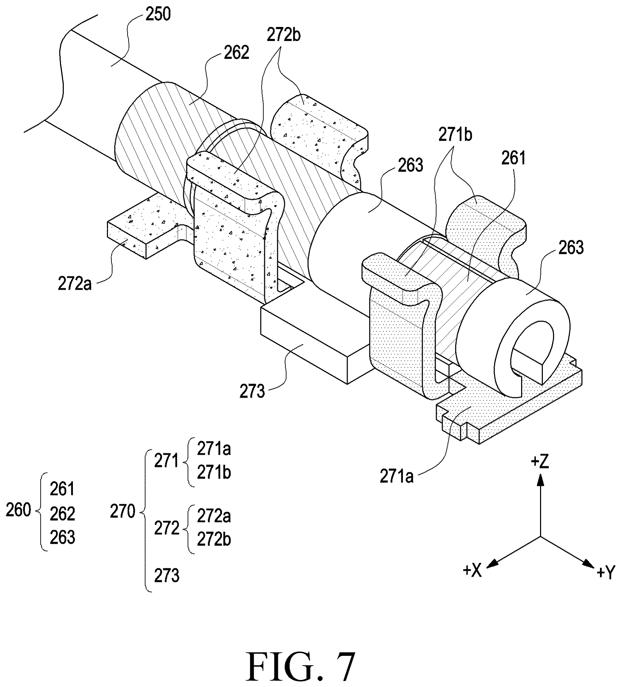

According to an embodiment, the electronic device 101 may include cable tubes 260A and 260B (e.g., the cable tube 260 of FIG. 7) connected to the end portion of the cable 250 and cable connection (or contact) members 270A and 270B (e.g., the cable connection member 270 of FIG. 7) disposed on the first circuit board 240a and the second circuit board 240b, respectively. According to an embodiment, the cable connection members 270A and 270B may be disposed to be seated and partially fixed on the cable connection members 270A and 270B by the manufacturer or the user pressing the cable tubes 260A and 260B in one direction. According to an embodiment, the cable connection members 270A and 270B and the cable tubes 260A and 260B may be configured to electrically connect (or bring into contact) the signal wire and the ground wire (or ground line) of the cable 250 to the first and second circuit boards 240a and 240b.

According to an embodiment, a circuit device (e.g., a processor), a communication module (e.g., the communication module 190 of FIG. 1), or memory, an interface, or various electrical/electronic components implemented in the form of an integrated circuit chip may be disposed on the printed circuit boards 240a and 240b. The processor may include one or more of a central processing unit, an application processor, a graphic processing device, an image signal processing, a sensor hub processor, or a communication processor. The memory may include, e.g., a volatile or non-volatile memory. The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector. According to an embodiment, the printed circuit boards 240a and 240b may be provided with an electromagnetic shielding environment from the rear case 280.

In an embodiment, at least a portion of the supporting structure 231 may be provided in a flat plate shape. In an embodiment, the supporting structure 231 may be disposed inside the electronic device 101 to be connected to the side bezel structure 232 or may be integrally formed with the side bezel structure 232. For example, the supporting structure 231 may be formed of a conductive material and/or a non-conductive material (e.g., polymer). When the supporting structure 231 at least partially includes a conductive material such as metal, a portion of the side bezel structure 232 or the supporting structure 231 may function as an antenna. The supporting structure 231 may include two surfaces facing in directions opposite to each other. The display 201 may be disposed on one of the two surfaces of the supporting structure 231, and the printed circuit boards 240a and 240b may be disposed on the other surface.

According to an embodiment, the supporting structure 231 and the side bezel structure 232 may be collectively referred to as a front case or a housing 230. According to an embodiment, the housing 230 may be generally understood as a structure for receiving, protecting, or disposing electrical/electronic components such as the printed circuit boards 240a and 240b or the battery 245. In an embodiment, it may be understood that the housing 230 includes a structure visually or tactilely recognizable by the user on the exterior of the electronic device 101, e.g., the side bezel structure 232, the front plate 202, and/or the rear plate 290. In an embodiment, the front surface or the rear surface of the housing 230 may refer to the first surface 210A of FIG. 2 or the second surface 210B of FIG. 3. In an embodiment, the supporting structure 231 may be disposed between the front plate 202 (e.g., the first surface 210A of FIG. 2) and the rear plate 290 (e.g., the second surface 210B of FIG. 3), and may function as a structure for disposing electrical/electronic components such as the printed circuit board 240a or 240b or the camera module 221. In the following description, as the camera module 221, a component receiving incident light through the second surface 210B of FIG. 3 may be exemplified, but the camera module 205 of FIG. 2 may also be disposed inside the electronic device 101 through the configuration of the embodiment described below.

In an embodiment, the rear case 280 may include an upper rear case 280a and a lower rear case 280b. In an embodiment, the upper rear case 280a may be disposed to surround the printed circuit boards 240a and 240b (e.g., the first circuit board 240a), together with a portion of the supporting structure 231. For example, the upper rear case 280a may be disposed to face the supporting structure 231 with the first circuit board 240a interposed therebetween.

In an embodiment, the lower rear case 280b may be utilized as a structure in which electrical/electronic components, such as an interface (e.g., a USB connector, an SD card/MMC connector, or an audio connector) may be disposed. According to an embodiment, electrical/electronic components, such as an interface (e.g., a USB connector, an SD card/MMC connector, or an audio connector) may be disposed on an additional printed circuit board (not illustrated). For example, the lower rear case 280b, together with the other part of the supporting structure 231, may be disposed to surround the additional printed circuit board (not illustrated). For example, an interface disposed in an additional printed circuit board not illustrated or the lower rear case 280b may be disposed corresponding to the audio hole 207 or the connector holes 208 and 209 of FIG. 2.

The battery 245 may be a device for supplying power to at least one component of the electronic device 101. The battery 450 may include, e.g., a primary cell which is not rechargeable, a secondary cell which is rechargeable, or a fuel cell. At least a portion of the battery 245 may be disposed on substantially the same plane as the printed circuit board 240a and 240b. The battery 245 may be integrally or detachably disposed inside the electronic device 101.

The antenna (not illustrated) may include, e.g., a conductor pattern implemented on the surface of the rear case 280 through a laser direct structuring method. In an embodiment, the antenna may include a printed circuit pattern formed on the surface of the thin film. The thin film-type antenna may be disposed between the rear plate 290 and the battery 245. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment, another antenna structure may be formed by a part or a combination of the supporting structure 231 and/or the side bezel structure 232.

In an embodiment, the camera module 221 may include at least one camera module, e.g., at least one of the plurality of camera modules illustrated in FIGS. 4 and 5. In an embodiment, the electronic device 101 may include at least one optical hole or a cover window 222, 223, 229. According to an embodiment, the camera module 221 may receive at least a portion of light incident through the optical hole or the cover windows 222, 223, and 229 inside the electronic device 101. In an embodiment, the camera module 221 may be disposed on a portion of the supporting structure 231 at a position adjacent to the printed circuit boards 240a and 240b. In an embodiment, the camera module 221 may be generally aligned with any one of the cover windows 222, 223, and 229, and may be at least partially surrounded by a rear case 280 (e.g., the upper rear case 280a).

Hereinafter, the cable 250, the cable tubes 260A and 260B (e.g., the cable tube 260 of FIG. 7), and the cable connection (or contact) members 270A and 270B (e.g., the cable connection member 270 of FIG. 7) constituting the cable and cable assembly are described in more detail with reference to FIGS. 7 to 16. The X, Y, and Z axes of the coordinate system of FIGS. 7 to 16 are exemplary for convenience of description, and may be changed according to the arrangement relationship with the electronic device 101.

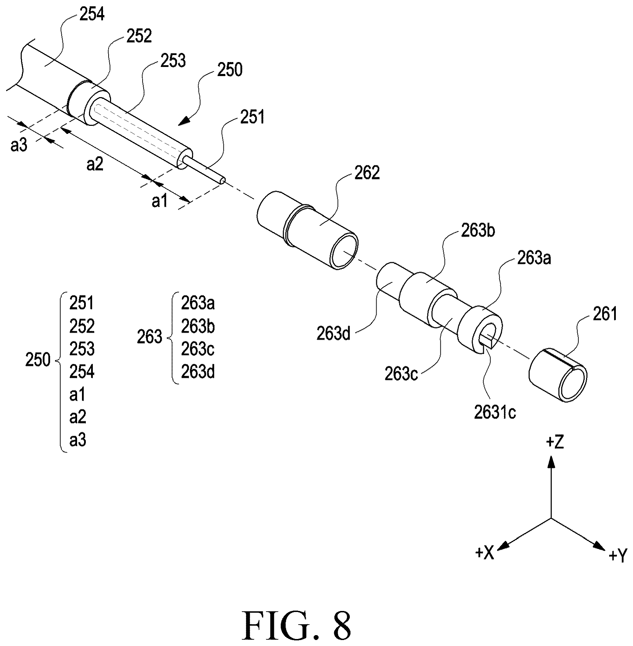

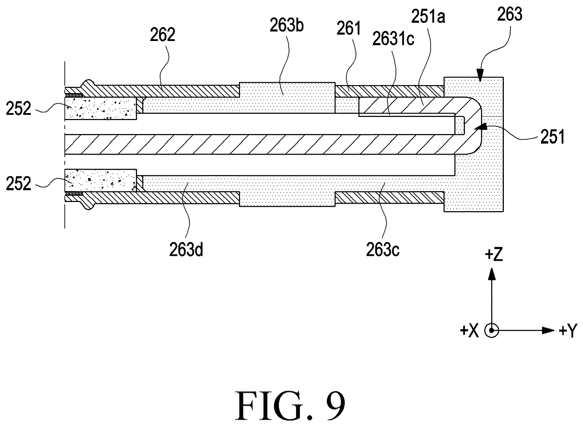

FIG. 7 is a perspective view illustrating a cable connection structure according to an embodiment of the disclosure. FIG. 8 is an exploded perspective view illustrating a cable assembly according to an embodiment of the disclosure. FIG. 9 is a cross-sectional view illustrating a cable assembly according to an embodiment of the disclosure.

Referring to FIGS. 7 to 9, in an embodiment, an electronic device (e.g., the electronic device 101 of FIGS. 1 to 5) may include a cable 250 (e.g., the cable 250 of FIGS. 4 to 6B), a plurality of printed circuit boards (e.g., the printed circuit boards 240a and 240b of FIGS. 4 and 5), a cable tube 260 (e.g., the cable tubes 260A and 260B of FIGS. 6A and 6B) for connecting the cable 250, and a cable connection member 270 (e.g., the cable connection members 270A and 270B of FIGS. 6A and 6B). According to an embodiment of the disclosure, the connection work of the cable 250 to the printed circuit board (e.g., the printed circuit boards 240a and 240b of FIGS. 4 and 5) may be simplified and the movement of the cable 250 may be limited in the connected state using the cable connection structure composed of the cable tube 260 and the cable connection member 270.

Referring to FIGS. 8 and 9, in an embodiment, a cable 250 (e.g., the coaxial cable) of the electronic device (e.g., the electronic device 101 of FIGS. 1 to 5) may include a signal wire 251, a ground wire 252, a first insulating sheath 253 disposed between the signal wire 251 and the ground wire 252, and a second insulating sheath 254 forming the appearance of the cable 250. For example, the first insulating sheath 253 may be configured to electrically separate the signal wire 251 from the ground wire 252. For example, the second insulating sheath 254 may be formed to surround the ground wire 252, and the second insulating sheath 254 may protect the internal structure of the cable 250, such as the signal wire 251, the first insulating sheath 253, and/or the ground wire 252. For example, the first insulating sheath 253 and the second insulating sheath 254 may include a non-conductive material (e.g., perfluoroalkoxy or fluorinated ethylene propylene). According to an embodiment, at the end portion (the end portion in the +Y direction) of the cable 250, the second insulating sheath 254, the ground wire 252, and/or the first insulating sheath 253 may be at least partially removed from an area where the cable tube 260 is disposed. Referring to FIGS. 8 and 9, according to an embodiment, the rest of the cable 250, except for the signal wire 251, may include a first area a1, a second area a2 extending from the first area a1 and where the second insulating sheath 254 and the ground wire 252 are removed, and a third area a3 extending from the second area a2 and where only the second insulating sheath 254 is removed. According to an embodiment, the first area a1, the second area a2, and the third area a3 may be sequentially disposed in a direction away from the end portion (the end portion in the +Y-direction) of the cable 250.

According to an embodiment, the cable tube 260 may include a first conductive tube 261 and a second conductive tube 262 connected to the signal wire 251 or the ground wire 252 of the cable 250, and an insulating tube 263 configured to insulate between the first conductive tube 261 and the second conductive tube 262. According to an embodiment, the first conductive tube 261 may be electrically connected to the signal wire 251 of the cable 250, and the second conductive tube 262 may be electrically connected to the ground wire 252. According to an embodiment, the first conductive tube 261 and the second conductive tube 262 may include a conductive material such as a metal (e.g., copper). For example, the first conductive tube 261 and/or the second conductive tube 262 may include copper or a copper alloy (e.g., phosphor bronze). For example, the first conductive tube 261 and/or the second conductive tube 262 may include a plating (e.g., gold plating) layer. For example, the insulating tube 263 may include a non-conductive material such as a polymer, and may include, e.g., a thermoplastic resin (e.g., polypropylene). According to an embodiment, the first conductive tube 261 and the second conductive tube 262 may be spaced apart from each other in the length direction (Y direction) of the cable 250 on the cable 250. According to an embodiment, the first conductive tube 261 of the cable tube 260 may be disposed closer to the end of the cable 250 than the second conductive tube 262. According to an embodiment, the insulating tube 263 may be disposed so that a portion (e.g., the second stepped portion 263b) blocks between the first conductive tube 261 and the second conductive tube 262.

According to an embodiment, the first conductive tube 261 and the second conductive tube 262 may be formed in a cylindrical or polygonal shape. According to an embodiment, the first conductive tube 261 and the second conductive tube 262 may be described as terminals. For example, the first conductive tube 261 may be described as a first connection terminal, and the second conductive tube 262 may be described as a second connection terminal.

According to an embodiment, the first conductive tube 261 may be electrically connected to the signal wire 251 of the cable 250. According to an embodiment, the first conductive tube 261 may connect the signal wire 251 to the input/output area (not illustrated) disposed on one surface of the printed circuit board (e.g., the printed circuit board 240a and 240b of FIGS. 4 and 5) through a cable connection member 270 (e.g., the first connection member 271). For example, the signal wire 251 of the cable 250 may be configured to transmit and/or receive electrical signals to/from the input/output area through the first conductive tube 261. Referring to FIGS. 8 and 9, according to an embodiment, the signal wire 251 of the first area a1 of the cable 250 may be bent to face the second area a2 in a state of being exposed from the first insulating sheath 253. According to an embodiment, the signal wire 251 may include a bent end portion 251a obtained by bending an end of the area to the outside of the first insulating sheath 253 to face the -Y direction. According to an embodiment, the bent end portion 251a of the signal wire 251 positioned in the first area a1 may be electrically connected by contacting the inner surface of the first conductive tube 261. For example, in the disclosure, the first area a1 may refer to a portion of the signal wire 251 exposed from the first insulating sheath 253 as a portion of the signal wire 251 positioned at the end of the cable 250, regardless of whether the signal wire 251 has been processed into the bent end portion 251a.

According to an embodiment, the second conductive tube 262 may be electrically connected to the ground wire 252 of the cable 250. According to an embodiment, the second conductive tube 262 may connect the ground wire 252 to the ground area (not illustrated) of the printed circuit board (e.g., the printed circuit boards 240a and 240b of FIGS. 4 and 5) through the cable connection member 270 (e.g., the second connection member 272). Referring to FIGS. 8 and 9, according to the embodiment, the second conductive tube 262 may be disposed on the second area a2 and the third area a3 of the cable 250. In other words, e.g., the second conductive tube 262 may be disposed to at least partially overlap (or face) the second area a2 and the third area a3 of the cable 250. According to an embodiment, the inner surface of the second conductive tube 262 may be electrically connected by contacting the ground wire 252 disposed to contact the third area a3 of the cable 250.

According to an embodiment, the insulating tube 263 may be disposed over the first area a1 and the second area a2 of the cable 250. For example, the insulating tube 263 may include a non-conductive material such as a polymer, and may include, e.g., a thermoplastic resin (e.g., polypropylene). According to an embodiment, the insulating tube 263 may be configured to separate and insulate between the signal wire 251 and the first conductive tube 261, and the ground wire 252 and the second conductive tube 262. For example, the insulating tube 263 may surround the first insulating sheath 253 positioned at the outermost portion of the second area a2 of the cable 250, and may be disposed not to overlap the ground wire 252 of the third area a3 of the cable 250.

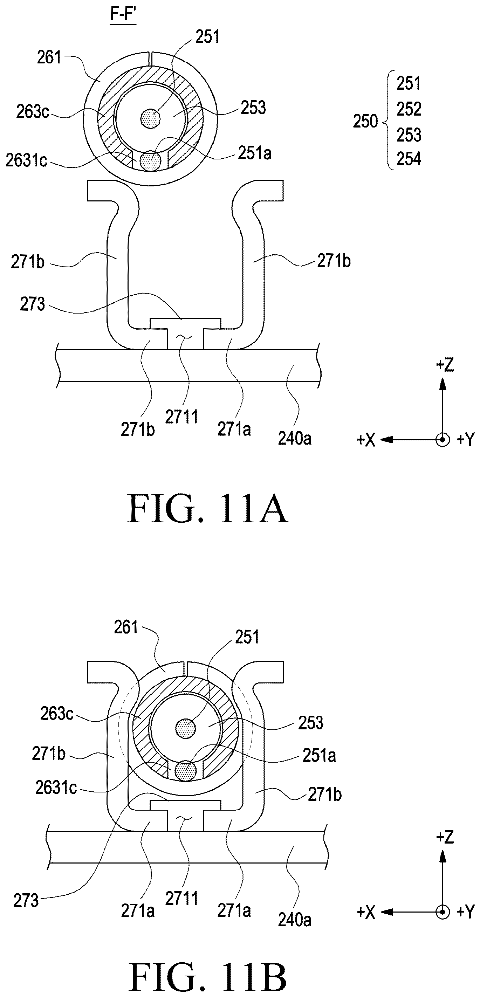

According to an embodiment, the insulating tube 263 may include a first seating portion 263c and a second seating portion 263d to seat the first conductive tube 261 and the second conductive tube 262, respectively. According to an embodiment, the insulating tube 263 may include a first stepped portion 263a forming an end portion of the cable tube 260 and the second stepped portion 263b disposed between the first and second seating portions 263c and 263d. For example, the first stepped portion 263a and/or the second stepped portion 263b may guide the mounting area of the first conductive tube 261 and/or the second conductive tube 262 to the first seating portion 263c and the second seating portion 263d, and may limit or prevent movement of the mounted first conductive tube 261 and/or the second conductive tube 262. Referring to FIGS. 8 and 9, in accordance with the embodiment, the insulating tube 263 may include a slit 2631c (e.g., the slit 2631c of FIGS. 11A and 11B) extending from the first stepped portion 263a to at least a portion of the second seating portion 263d. For example, the slit 2631c of the insulating tube 263 may allow the bent end portion 251a of the signal wire 251 to pass therethrough when assembling by inserting the insulating tube 263 onto the end portion of the cable 250. According to an embodiment, when the slit 2631c is formed in the insulating tube 263, the slit 2631c may serve to guide the assembly direction of the insulating tube 263 with respect to the cable 250.

In an embodiment, the cable connection member 270 may include a first connection member 271 to be electrically connected to the first conductive tube 261 of the cable tube 260 and a second connection member 272 to be electrically connected to the second conductive tube 262. According to an embodiment, the first connection member 271 may be electrically connected to the signal wire 251 of the cable 250 through the first conductive tube 261, and the second connection member 272 may be electrically connected to the ground wire 252 of the cable 250 through the second conductive tube 262. According to an embodiment, the first connection member 271 and the second connection member 272 may include a conductive material such as metal. For example, the first connection member 271 and the second connection member 272 may include copper or a copper alloy (e.g., phosphor bronze), and for example, may further include a plating layer.

According to an embodiment, the cable connection member 270 may further include an insulating bracket 273 configured to connect the first connection member 271 and the second connection member 272 and insulate the two members from each other. For example, the insulating bracket may include a non-conductive material such as a polymer, and may include, e.g., a thermoplastic resin (e.g., polypropylene).

According to an embodiment, the cable connection member 270 may include a first portion 271a, 272a mounted on the printed circuit board (e.g., the printed circuit boards 240a and 240b of FIGS. 4 and 5) and a plurality of second portions 271b and 272b extending from the first portion 271a, 272a and supporting the cable tube 260 in the width direction (X direction). According to an embodiment, the first connection member 271 may include a 1-1th portion 271a and a plurality of 1-2th portions 271b, and the second connection member 272 may include a 2-1th portion 272a and a plurality of 2-2th portions 272b. According to an embodiment, the 1-2th portions 271b of the first connection member 271 may be electrically connected to the signal wire 251 through the first conductive tube 261 by contacting the first conductive tube 261. According to an embodiment, the 2-2th portions 272b of the second connection member 272 may be electrically connected to the ground wire 252 through the second conductive tube 262 by contacting the second conductive tube 262.

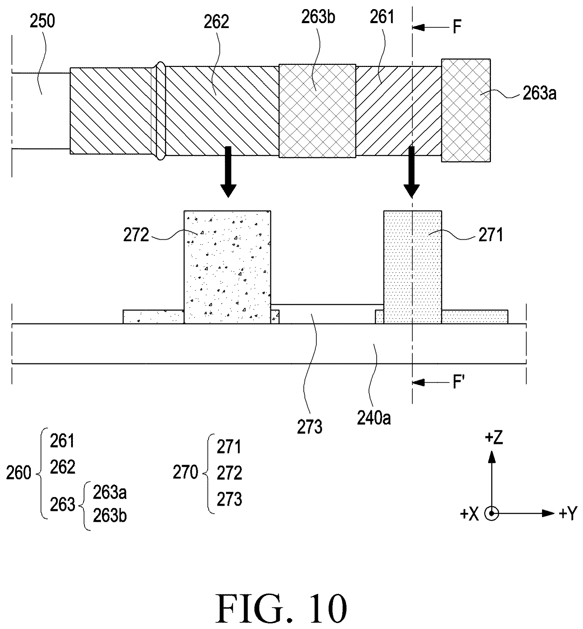

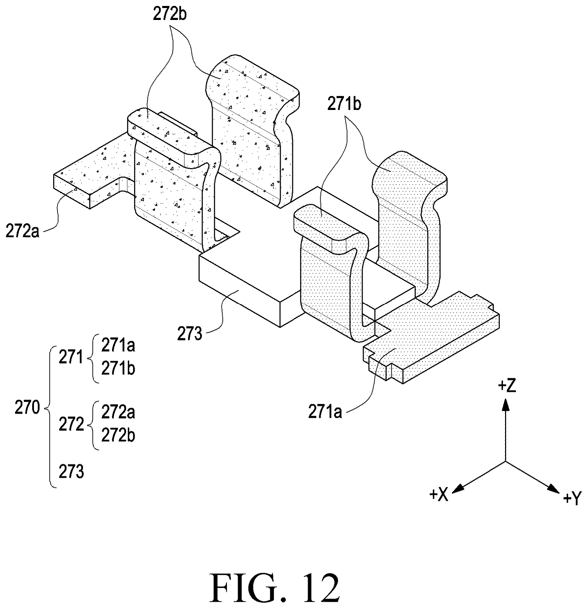

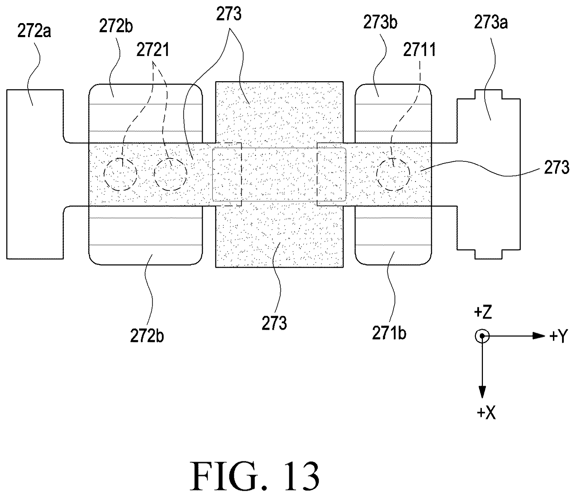

FIG. 10 is a side view illustrating a cable connection structure before assembly according to an embodiment of the disclosure. FIG. 11a is a cross-sectional view taken along line F-F' of FIG. 10. FIG. 11B is a cross-sectional view illustrating the cable connection structure of FIG. 11A in an assembled state. FIG. 12 is a perspective view illustrating a cable connection member according to an embodiment of the disclosure. FIG. 13 is a plan view illustrating a cable connection member according to an embodiment of the disclosure.

The cable 250, the cable tube 260, and the cable connection member 270 of FIGS. 10 to 13 may be referred to as the cable 250, the cable tube 260, and the cable connection member 270 according to the embodiment described above with reference to FIGS. 7 to 9.

According to an embodiment, the cable tube 260 may be mounted or coupled to the cable connection member 270 by being pressed in one direction. Referring to FIGS. 10 to 13, the second portions 271b and 272b of the cable connection member 270 according to an embodiment may be configured to guide an installation direction of the cable tube 260. According to an embodiment, the pair of second portions 271b and 272b may be disposed to face each other with a seating space for receiving the cable tube 260 therebetween. For example, the cable tube 260 may be seated on the cable connection member 270 by being pressed toward the first portion 271a, 272a through an opening between the end portions of the second portions 271b and 272b. For example, the cable tube 260 may be mounted on the cable connection member 270 in the direction of the arrow of FIG. 10. Referring to FIGS. 11A and 11B, according to an embodiment, the respective end portions of the pair of second portions 271b and 272b may be curved in directions away from each other, and thus curved surfaces may be included in the areas in contact with the cable tube 260. For example, the cable tube 260 may be guided to a seating space between the second portions 271b and 272b along the curved surfaces of the second portions 271b and 272b. For example, the second portions 271b and 272b of the first connection member 271 and the second connection member 272 may be formed to be elastically deformable.

According to an embodiment, the first connection member 271 and the second connection member 272 may be coupled on a printed circuit board (e.g., the printed circuit boards 240a and 240b of FIGS. 4 and 5), e.g., through soldering or fastening means (e.g., bolts). According to an embodiment, when the cable connection member 270 includes an insulating bracket connecting the first connection member 271 and the second connection member 272, they, as a single integrated member, may be coupled to the printed circuit boards 240a and 240b simultaneously. Referring to FIG. 13, in an embodiment, one or more through holes 2711 and 2721 for connection to the insulating bracket may be formed in the 1-1th portion 271a of the first connection member 271 and/or the 2-1th portion 272a of the second connection member 272. According to an embodiment, the insulating bracket may include a protrusion formed to be engaged with the through holes 2711 and 2721 of the 1-1th portion 271a and/or the 2-1th portion 272a. However, the insulating bracket, the first connection member 271, and the second connection member 272 may be coupled not only through a coupling structure such as the protrusion and the through holes 2711 and 2721, but also through adhesive materials or fastening means (e.g., bolts).

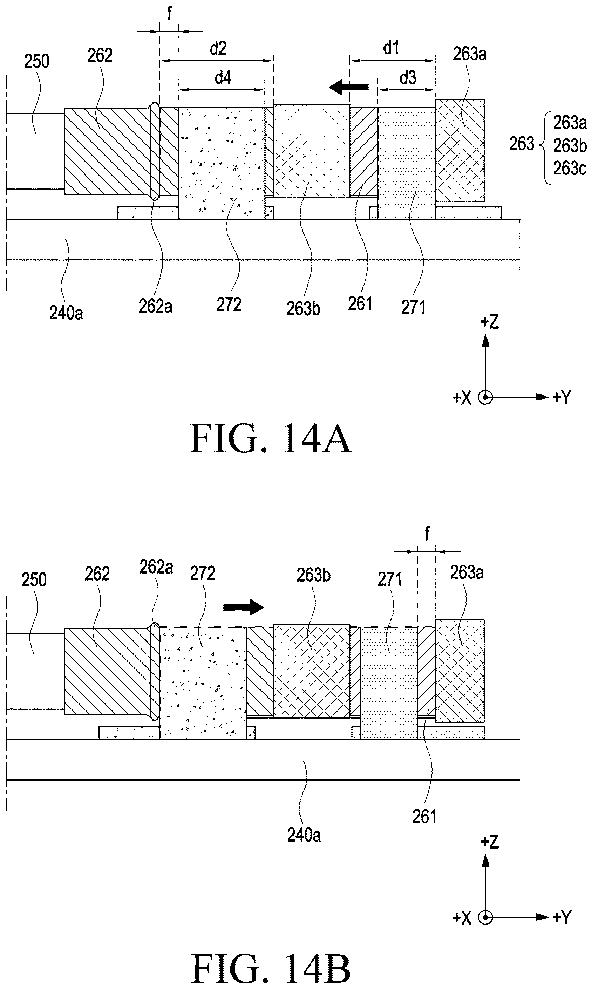

FIG. 14A is a side view illustrating a cable connection structure according to an embodiment of the disclosure. FIG. 14B is a side view illustrating a cable connection structure according to an embodiment of the disclosure.

The cable 250, the cable tube 260, and the cable connection member 270 of FIGS. 14A and 14B may be referred to as the cable 250, the cable tube 260, and the cable connection member 270 according to the embodiment described above with reference to FIGS. 7 to 13.

Referring to FIGS. 14A and 14B, the cable connection member 270 may be configured to allow the movement of the cable tube 260 in one axial direction (length direction or Y direction of the cable 250) by a designated distance f. According to an embodiment, the first stepped portion 263a of the insulating tube 263 may have a diameter or height (the length in the Z direction) larger than that of the second stepped portion 263b, and may function as a stopper for limiting movement (e.g., movement in the +Y direction) of the first conductive tube 261. According to an embodiment, the insulating tube 263 may include a stopper 262a for limiting movement (e.g., movement in the -Y direction) of the second conductive tube 262. For example, the stopper 262a may have a shape that further protrudes in an outer direction (Z direction) compared to the second stepped portion 263b. For example, referring to FIG. 14A, the cable tube 260 may move by a designated distance f in the direction of the arrow in FIG. 14A with respect to the cable connection member 270. For example, referring to FIG. 14B, the cable tube 260 may move by a designated distance f in the direction of the arrow in FIG. 14B with respect to the cable connection member 270.

According to an embodiment, the length d1 of the first seating portion 263c of the insulating tube 263 may be smaller than the length d3 of the first conductive tube 261. According to an embodiment, the length d2 of the second seating portion 263d of the insulating tube 263 may be smaller than the length d4 of the second conductive tube 262. For example, the length d2 of the second seating portion 263d may be larger than or equal to the length d1 of the first seating portion 263c, and for example, the length d4 of the second conductive tube 262 may be larger than or equal to the length d3 of the first conductive tube 261. For example, the designated distance f, which is a movable distance of the cable tube 260, may be smaller than the difference between the length d1 of the first seating portion 263c and the length d3 of the first conductive tube 261 or the length d2 of the second seating portion 263d and the length d4 of the second conductive tube 262.

According to an embodiment, the cable connection member 270 may prevent or reduce the connection failure or damage to the cable tube 260 and the cable connection member 270 due to the displacement of the cable 250 due to the external impact applied to the electronic device (e.g., the electronic device 101 of FIGS. 1 to 5). For example, the cable tube 260 and the cable connection member 270 may prevent or reduce the damage to the cable 250 by limiting or restraining the movement or rotation of the cable 250 in the width direction (X direction) and the height direction (Z direction).

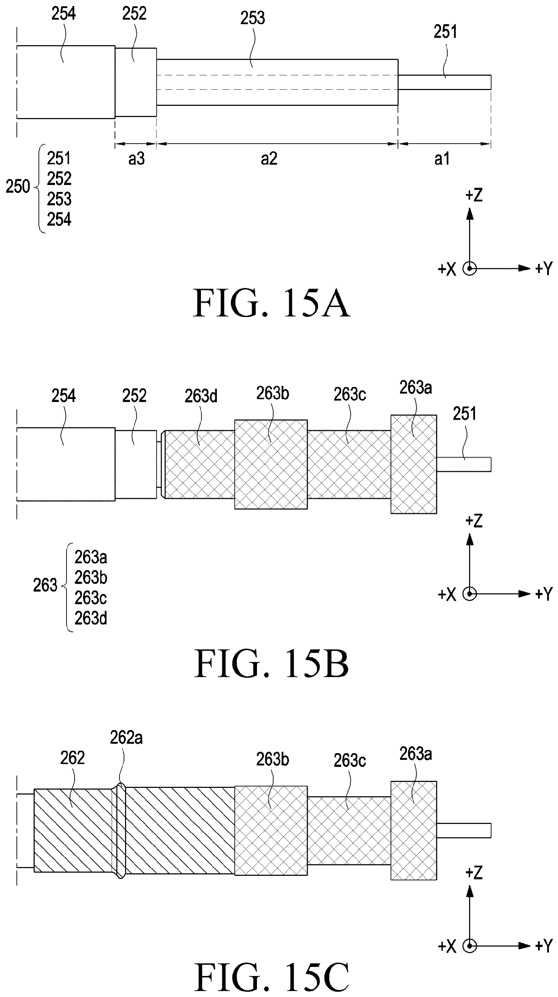

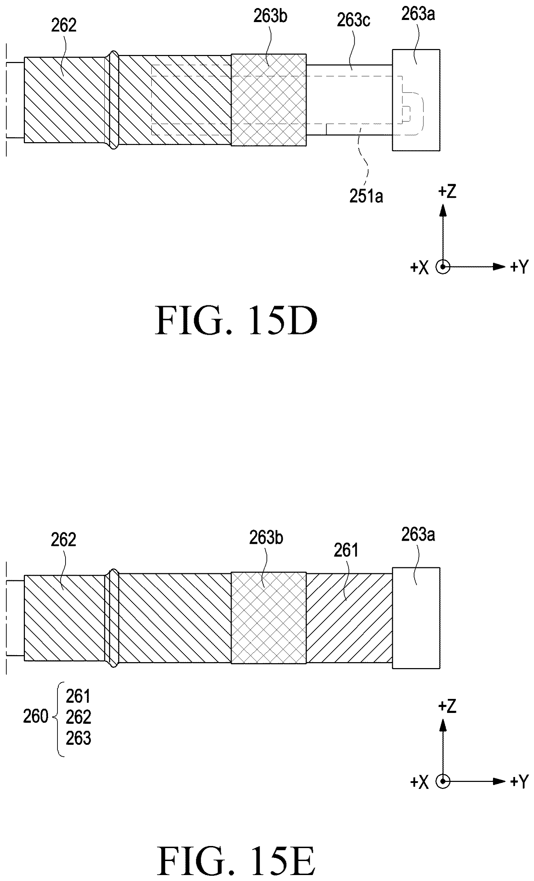

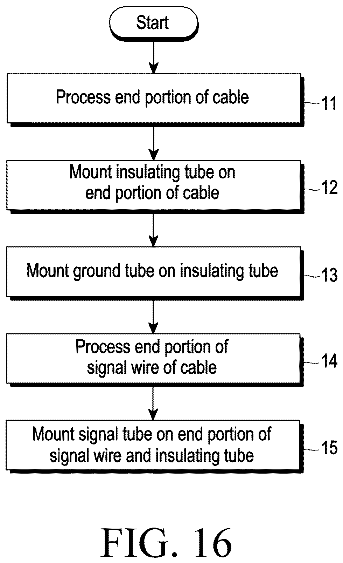

FIG. 15A is a side view illustrating a cable according to an embodiment of the disclosure. FIG. 15B is a side view illustrating a cable and an insulating tube according to an embodiment of the disclosure. FIG. 15C is a side view illustrating a cable, a second conductive tube, and an insulating tube according to an embodiment of the disclosure. FIG. 15D is a side view illustrating a state in which a signal line of a cable is processed in FIG. 15C. FIG. 15E is a side view illustrating a cable, a first conductive tube, a second conductive tube, and an insulating tube according to an embodiment of the disclosure. FIG. 16 is a flowchart illustrating a method for manufacturing a cable tube according to an embodiment of the disclosure.

The cable 250 and the cable tube 260 of FIGS. 15A to 15E may be referred to as the cable 250 and the cable tube 260 according to the embodiment described above with reference to FIGS. 7 to 14B.

Referring to FIG. 16, according to an embodiment of the disclosure, a method of installing or mounting a cable tube on a cable may include a first process 11 of processing an end portion of a cable 250, a second process 12 of mounting an insulating tube 263 on the end portion of the cable 250, a third process 13 of mounting a ground tube (e.g., the second conductive tube 262 of FIGS. 7 to 10, 14A, and 14B) on the insulating tube 263, a fourth process 14 of processing an end portion (e.g., the bent end portion 251a of FIGS. 9, 11A, and 11B) of the signal wire 251 of the cable 250, and a fifth process 15 of mounting a signal tube (e.g., the first conductive tube 261 of FIGS. 7 to 11B, 14A, and 15B) on the end portion (e.g., the bent end portion 251a of FIGS. 9, 11A, and 11B) of the signal wire 251 and the insulating tube 263.

Referring to FIG. 15A, according to an embodiment, in the first process 11 of processing the end portion of the cable 250, at least a portion of the area of the cable 250 to which the cable tube 260 is mounted may be processed. For example, in the area where the cable tube 260 is disposed in the end portion of the cable 250, the second insulating sheath 254, the ground wire 252, and/or the first insulating sheath 253 may be at least partially removed. According to an embodiment, the cable 250 may be processed to include a first area a1 in which only the signal wire 251 is left, a second area a2 in which only the signal wire 251 and the first insulating sheath 253 are left, and a third area a3 in which only the second insulating sheath 254 is removed.

Referring to FIG. 15B, in the second process 12 of mounting the insulating tube 263 on the end portion of the cable 250, the insulating tube 263 may be mounted around the cable 250. For example, the insulating tube 263 may be mounted to overlap a portion of the first area a1 and a portion of the second area a2.

Referring to FIG. 15C, in the third process 13 of mounting the ground tube (e.g., the second conductive tube 262 of FIGS. 7 to 10, 14A and 14B) on the insulating tube 263, the second conductive tube 262 may be mounted to surround the third area a3 of the cable 250 of the insulating tube 263. According to an embodiment, the second conductive tube 262 may be electrically connected to the ground wire 252 of the third area a3. For example, the inner surface of the second conductive tube 262 may contact the ground wire 252. For example, a portion of the second conductive tube 262 may be seated on the second seating portion 263d of the insulating tube 263, and another portion may be disposed to surround the second insulating sheath 254 of the cable 250.

Referring to FIG. 15D, according to an embodiment, in the fourth process 14 of processing the end portion (e.g., the bent end portion 251a of FIGS. 9, 11A and 11B) of the signal wire 251 of the cable 250, the signal wire 251 of the first area a1 of the cable 250 may be bent toward the second area a2 while being exposed from the first insulating sheath 253. According to an embodiment, the signal wire 251 may include a bent end portion 251a processed so that an end portion of the area exposed to the outside of the first insulating sheath 253 faces the -Y direction.

Referring to FIG. 15E, according to an embodiment, in the fifth process 15 of mounting the signal tube (e.g., the first conductive tube 261 of FIGS. 7 to 11B, 14A, and 15B) on the end portion (e.g., the bent end portion 251a of FIGS. 9, 11A, and 11B) of the signal wire 251, the first conductive tube 261 may be mounted to surround the first seating portion 263c of the insulating tube 263. According to an embodiment, the first conductive tube 261 may be electrically connected to the bent end portion 251a of the signal wire 251 exposed through the slit (e.g., the slit 263c of FIGS. 9, 11A and 11B) of the first seating portion 263c. For example, the inner surface of the first conductive tube 261 may contact the bent end portion 251a of the signal wire 251.

Objects of the disclosure are not limited to those mentioned, but may rather be diverse without departing from the spirit and scope of the disclosure.

Effects obtainable from the disclosure are not limited to the above-mentioned effects, and other effects not mentioned may be apparent to one of ordinary skill in the art from the following description.

Other aspects according to various embodiments will be suggested through in the following detailed description and would be partially apparent from the description or appreciated through the suggested embodiments.

According to an embodiment of the disclosure, an electronic device 101 may be provided. The electronic device may comprise a printed circuit board 240a, 240b, a cable 250 including a signal wire 251, a ground wire 252, and an insulating sheath 253, 254 surrounding the signal wire and the ground wire, a cable tube 260 disposed to surround an end portion of the cable, and a cable connection member 270 disposed on the printed circuit board. The cable tube may include a first conductive tube 261 to be electrically connected to the signal wire and a second conductive tube 262 spaced apart from the first conductive tube and to be electrically connected to the ground wire. The cable connection member may include a first connection member 271 to be electrically connected to the first conductive tube and a second connection member 272 to be electrically connected to the second conductive tube.

According to an embodiment, the first conductive tube may be electrically connected to an input/output area on the printed circuit board through the first connection member, and the second conductive tube may be electrically connected to a ground area on the printed circuit board through the second connection member.

According to an embodiment, the first conductive tube and the second conductive tube may be spaced apart from each other in a first axial direction which is a length direction of the cable.

According to an embodiment, the cable tube may further include an insulating tube 263 disposed to at least partially surround the end portion of the cable. The insulating tube may be configured to allow at least a portion of the first conductive tube and the second conductive tube to be mounted on the insulating tube

According to an embodiment, the insulating sheath of the cable may include a first insulating sheath 253 disposed between the signal wire and the ground wire. At least a portion of the insulating tube may be disposed between the second conductive tube and the first insulating sheath.

According to an embodiment, the insulating tube includes a first stepped portion 263a forming an end portion of the insulating tube, a first seating portion 263c extending from the first stepped portion and to seat the first conductive tube, a second stepped portion 263b extending from the first seating portion, and a second seating portion 263d extending from the second stepped portion and to seat at least a portion of the second conductive tube.

According to an embodiment, at least one of the first stepped portion and the second stepped portion may be configured to limit a range of movement in the first axial direction to a designated distance by contacting the first connection member or the second connection member when the cable moves in the first axial direction with respect to the connection member.

According to an embodiment, the first conductive tube may not overlap the ground wire and the second conductive tube in a second axial direction crossing the first axial direction.

According to an embodiment, at least a portion of an inner surface of the first conductive tube may at least partially contact the signal wire.

According to an embodiment, the signal wire may include a bent end portion 251a in contact with an inner surface of the first conductive tube. The insulating tube may include a slit 2631c through which the bent end portion passes.

According to an embodiment, the first connection member may include a 1-1th portion connected to an input/output terminal of the printed circuit board and a pair of 1-2th portions extending from the 1-1th portion and supporting the second conductive tube from two opposite sides.

According to an embodiment, the second conductive tube may further include a stopper protruding from an outer surface of the second conductive tube. The stopper may be configured to limit the range of movement of the cable in the first axial direction to the designated distance by contacting the 1-2th portions when the cable moves in the first axial direction with respect to the connection member.

According to an embodiment, the second connection member may include a conductive 2-1th portion connected to a ground terminal of the printed circuit board and a pair of 2-2th portions extending from the 2-1th portion and supporting the second conductive tube from two opposite sides.

According to an embodiment, the cable tube may be mounted on the cable connection member in a second axial direction crossing the first axial direction.

According to an embodiment of the disclosure, there may be provided a method for manufacturing a cable tube 260. The method for manufacturing the cable tube may comprise a first process 11 of processing an end portion of the cable 250, a second process 12 of mounting an insulating tube 263 on the end portion of the cable, a third process 13 of mounting a ground tube 262 on the insulating tube, and a fifth process 15 of mounting a signal tube 261 on a bent end portion 251a of the signal wire and the insulating tube.

According to an embodiment, the cable may include a structure in which a signal wire 251 disposed in a center, a first insulating sheath 253, a ground wire 252, and a second insulating sheath 254 are sequentially stacked.

The first process 11 may include a process of removing the second insulating sheath and the ground wire of a first area a1 and a second area a2 where at least a portion of the insulating tube is mounted.

According to an embodiment, the first process 11 may include a process of removing the first insulating sheath of the first area positioned at an end of the cable.

According to an embodiment, the method may further comprise a fourth process 14 of processing an end portion of the signal wire 251 of the cable to process the end portion of the signal wire of the first area into a bent end portion by bending the end portion of the signal wire toward the second area.

The insulating tube may include a slit 2631c through which the bent end portion passes.

According to an embodiment, the second process 12 may include a process of fitting the insulating tube to the end portion of the cable in a first axial direction, which is a length direction of the cable. At least one of the third process 13 or the fifth process 15 may include a process of mounting the ground tube or the signal tube around the cable in a second axial direction crossing the first axial direction (Y-axis direction).

According to an embodiment of the disclosure, a cable assembly may be provided. The cable assembly may comprise a cable 250 including a signal wire 251, a ground wire 252, and an insulating sheath 253, 254 surrounding the signal wire and the ground wire, a cable tube 260 disposed to surround an end portion of the cable, and a cable connection member 270. The cable tube may include a first conductive tube 261 to be electrically connected to the signal wire and a second conductive tube 262 spaced apart from the first conductive tube in a first axial direction which is a length direction of the cable and to be electrically connected to the ground wire. The connection member may include a first connection member 271 to be electrically connected to the first conductive tube and a second connection member 272 to be electrically connected to the second conductive tube.

According to an embodiment, the cable connection member may be disposed on a circuit board 240a, 240b positioned outside the cable assembly. The first conductive tube may be electrically connected to an input/output area on the circuit board through the first connection member, and the second conductive tube is electrically connected to a ground area on the circuit board through the second connection member.

According to an embodiment, the insulating sheath of the cable may include a first insulating sheath 253 disposed between the signal wire and the ground wire. The cable tube may further include an insulating tube 263 disposed to at least partially surround the end portion of the cable. At least a portion of the insulating tube may be disposed between the second conductive tube and the first insulating sheath.

According to an embodiment, the insulating tube includes a first stepped portion 263a forming an end portion, a first seating portion 263c extending from the first stepped portion and to seat the first conductive tube, a second stepped portion 263b extending from the first seating portion, and a second seating portion 263d extending from the second stepped portion and to seat at least a portion of the second conductive tube.

According to an embodiment, the cable tube may be mounted on the cable connection member in a second axial direction crossing the first axial direction.

While the disclosure has been described and shown in connection with an embodiment, it should be appreciated that an embodiment is intended as limiting the invention but as illustrative. It will be apparent to one of ordinary skill in the art that various changes may be made in form and detail without departing from the overall scope of the disclosure, including the appended claims and their equivalents.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components or processes may be omitted, or one or more other components or processes may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, processes performed by the module, the program, or another component may be carried out sequentially, in parallel, repeatedly, or heuristically, or one or more of the processes may be executed in a different order or omitted, or one or more other processes may be added.

## Claims

1. An electronic device (101), comprising:
a printed circuit board (240a; 240b);
a cable (250) including a signal wire (251), a ground wire (252), and an insulating sheath (253; 254) surrounding the signal wire and the ground wire;
a cable tube (260) disposed to surround an end portion of the cable, and including a first conductive tube (261) to be electrically connected to the signal wire and a second conductive tube (262) spaced apart from the first conductive tube and to be electrically connected to the ground wire; and
a cable connection member (270) disposed on the printed circuit board, and including a first connection member (271) to be electrically connected to the first conductive tube and a second connection member (272) to be electrically connected to the second conductive tube.

2. The electronic device of claim 1, wherein the first conductive tube is electrically connected to an input/output area on the printed circuit board through the first connection member, and the second conductive tube is electrically connected to a ground area on the printed circuit board through the second connection member.

3. The electronic device of claim 1 or 2, wherein the first conductive tube and the second conductive tube are spaced apart from each other in a first axial direction which is a length direction of the cable.

4. The electronic device of claim 3, wherein the cable tube further includes an insulating tube (263) disposed to at least partially surround the end portion of the cable, and allowing at least a portion of the first conductive tube and the second conductive tube to be mounted on the insulating tube.

5. The electronic device of claim 4, wherein the insulating sheath of the cable includes a first insulating sheath (253) disposed between the signal wire and the ground wire, and at least a portion of the insulating tube is disposed between the second conductive tube and the first insulating sheath.

6. The electronic device of claim 4 or 5, wherein the insulating tube includes a first stepped portion (263a) forming an end portion of the insulating tube, a first seating portion (263c) extending from the first stepped portion and to seat the first conductive tube, a second stepped portion (263b) extending from the first seating portion, and a second seating portion (263d) extending from the second stepped portion and to seat at least a portion of the second conductive tube.

7. The electronic device of claim 6, wherein at least one of the first stepped portion and the second stepped portion is configured to limit a range of movement in the first axial direction to a designated distance by contacting the first connection member or the second connection member when the cable moves in the first axial direction with respect to the connection member.

8. The electronic device of claim 7, wherein the first conductive tube does not overlap the ground wire and the second conductive tube in a second axial direction crossing the first axial direction.

9. The electronic device of any one of claims 4 to 8, wherein at least a portion of an inner surface of the first conductive tube at least partially contacts the signal wire.

10. The electronic device of claim 9, wherein the signal wire includes a bent end portion (251a) in contact with an inner surface of the first conductive tube, and the insulating tube includes a slit (2631c) through which the bent end portion passes.

11. The electronic device of any one of claims 3 to 10, wherein the first connection member includes a 1-1th portion connected to an input/output terminal of the printed circuit board and a pair of 1-2th portions extending from the 1-1th portion and supporting the second conductive tube from two opposite sides.

12. The electronic device of claim 11, wherein the second conductive tube further includes a stopper protruding from an outer surface of the second conductive tube, and the stopper is configured to limit the range of movement of the cable in the first axial direction to the designated distance by contacting the 1-2th portions when the cable moves in the first axial direction with respect to the connection member.

13. The electronic device of any one of claims 1 to 12, wherein at least a portion of an inner surface of the second conductive tube contacts a portion of the ground wire.

14. The electronic device of any one of claims 1 to 13, wherein the second connection member includes a conductive 2-1th portion connected to a ground terminal of the printed circuit board and a pair of 2-2th portions extending from the 2-1th portion and supporting the second conductive tube from two opposite sides.

15. A cable assembly comprising:
a cable (250) including a signal wire (251), a ground wire (252), and an insulating sheath (253; 254) surrounding the signal wire and the ground wire;
a cable tube (260) disposed to surround an end portion of the cable, and including a first conductive tube (261) to be electrically connected to the signal wire and a second conductive tube (262) spaced apart from the first conductive tube in a first axial direction which is a length direction of the cable and to be electrically connected to the ground wire; and
a cable connection member including a first connection member (271) to be electrically connected to the first conductive tube and a second connection member (272) to be electrically connected to the second conductive tube.
